# EUROPÄISCHE PATENTSCHRIFT

(11) **EP 3 424 141 B1**
(45) Veröffentlichungstag und Bekanntmachung des Hinweises auf die Patenterteilung: **28.04.2021**
(21) Anmeldenummer: 17716295.5
(22) Anmeldetag: 04.03.2017
(51) Int. Cl.: H02S 20/26, H01L 31/042, H02S 20/22, H02S 40/22, E06B 7/08

(54) **GITTERSTRUKTUR FÜR PHOTOVOLTAIKMODUL**
LATTICE STRUCTURE FOR PHOTOVOLTAIC MODULE
STRUCTURE EN RÉSEAU POUR MODULE PHOTOVOLTAÏQUE

(30) Priorität: 04.03.2016 DE 102016002548
(43) Veröffentlichungstag der Anmeldung: 09.01.2019
(73) Patentinhaber: Hochschule Luzern, 6048 Horw (CH)
(72) Erfinder: WITTKOPF, Stephen, 6052 Hergiswil (CH)
(74) Vertreter: Linhart, Friedrich Karl Eberhard
(86) Internationale Anmeldenummer: PCT/IB2017/000211
(87) Internationale Veröffentlichungsnummer: WO 2017/149382

(56) Entgegenhaltungen:
- ES-A1- 2 362 912
- US-A- 3 072 230
- US-A1- 2009 183 764

## Beschreibung

### Technisches Gebiet

Die Erfindung betrifft eine Gebäudefassade nach dem Oberbegriff des Anspruchs 1.

### Stand der Technik

Photovoltaikmodule werden heutzutage vielerorts eingesetzt. Ein möglicher Einsatzort für Photovoltaikanlagen sind Gebäudefassaden, man spricht in diesem Zusammenhang auch von BIPV-Anwendungen, wobei BIPV für "building integrated photovoltaics" steht.

Bei solchen BIPV-Anwendungen geht es nicht zwangsläufig darum, dass die verwendeten Photovoltaikmodule möglichst effizient elektrischen Strom produzieren. Vielmehr spielen bei der Integration von Photovoltaikmodulen in Gebäudefassaden auch ästhetische Aspekte eine entscheidende Rolle bei der Bewilligung von Bauprojekten.

In diesem Zusammenhang besteht unter anderem ein Bedarf an Photovoltaikmodulen, welche von Gebäudebetrachtern, insbesondere Personen, welche sich auf Strassenniveau befinden, nicht auf den ersten Blick als Photovoltaikmodule zu erkennen sind. Oft wird von solchen Betrachtern nämlich die typischerweise dunkle Farbe der Photovoltaikmodule als unangenehm befunden, bzw. bei Bauprojekten haben durch BIPV-Anwendungen bedingte dunkle Fassadenfarben schlechte Bewilligungschancen.

Eine Möglichkeit, das typischerweise dunkle Erscheinungsbild von Photovoltaikmodulen zu kaschieren, ist die Verwendung von farbigen Abdeckgläsern, welche über den dunklen Solarzellen montiert werden und auf diese Weise einen freundlicheren Anblick erzeugen. Solche farbigen Abdeckgläser haben jedoch verschiedene Nachteile, nämlich zum Beispiel, dass sie verhältnismässig aufwendig und teuer herzustellen sind und dass sie anfällig für Beschädigungen durch mechanische Einflüsse und für Verschmutzungen sind.

Die ES 2 362 912 A1 beschreibt einen Reflexions-Solarkonzentrator, bei welchem eine reflektierende Lamellenstruktur Sonnenlicht auf Solarzellen umlenkt, welche auf einer Fassade angeordnet sind.

### Aufgabe der Erfindung

Es ist die Aufgabe der Erfindung, die Nachteile des vorgenannten Stands der Technik zu beheben bzw. zumindest abzuschwächen. Insbesondere ist es die Aufgabe der Erfindung, eine einfache und günstige Möglichkeit zu schaffen, das ästhetische Erscheinungsbild von BIPV-Anwendungen zu verbessern und gleichzeitig eine bestmögliche Energieeffizienz bei diesen BIPV-Anwendungen zu gewährleisten.

### Lösung der Aufgabe

Die Aufgabe wird erfindungsgemäss gelöst durch eine Gitterstruktur zur Montage auf einem Photovoltaikmodul, wobei die Gitterstruktur derart ausgebildet ist, dass sie, in einem auf dem Photovoltaikmodul montierten Zustand, wobei das Photovoltaikmodul selbst in eine Gebäudefassade integriert ist, geeignet ist, auf die Gitterstruktur treffendes Licht derart in Richtung des Photovoltaikmoduls umzulenken, dass eine möglichst homogene Ausleuchtung des Photovoltaikmoduls erreicht wird.

Eine derartige Gitterstruktur löst die oben genannte Aufgabe deshalb, weil zum einen durch die homogene Ausleuchtung des Photovoltaikmoduls eine gute Energieeffizienz erreicht wird, zum Beispiel, weil eine Hot-Spot-Bildung vermieden wird, und weil die Gitterstruktur andererseits geeignet ist, ein gebäudeintegriertes Photovoltaikmodul derart zu kaschieren, dass es zum Beispiel von Fussgängern nicht als solches erkennbar ist.

Bei vorteilhaften Ausführungsformen ist die Gitterstruktur zumindest zum Teil hell und/oder matt und/oder weiss. "Hell" bedeutet hierbei, dass die Gitterstruktur einen Reflexionsgrad von mindestens 50%, bevorzugt mindestens 60%, besonders bevorzugt mindestens 65% hat. "Matt" bedeutet hierbei, dass auf die Gitterstruktur auftreffendes direktes Sonnenlicht nach der Reflexion gestreuter und damit kontrastärmer wird, was die Bildung von schädlichen Hot Spots erschwert. Eine derart ausgebildete Gitterstruktur hat den Vorteil, dass sie ein freundliches und neutrales Erscheinungsbild bietet und zudem geeignet ist, verhältnismässig viel Licht besonders homogen auf dem Photovoltaikmodul zu verteilen.

Bei vorteilhaften Ausführungsformen umfasst die Gitterstruktur eine Mehrzahl an Lamellen und eine Mehrzahl an Maschen. Unter dem Begriff "Lamelle" ist dabei eine horizontale streifenförmige Gitterstrebe zu verstehen, welche typischerweise nicht vollständig plan ist, sondern eine gewisse Verdrehung, beispielsweise um ihre Längsachse und/oder um ihre Querachse aufweist. Eine solche Lamelle erinnert beispielsweise an eine Bandnudel. Die Lamellen bilden bei einer solchen Gitterstruktur dann zwischen einander jeweils die Maschen aus, wobei jede Masche einen offenen Bereich, d.h. einen Schlitz, hat. Dabei ist der Schlitz bevorzugt rautenförmig. Eine derart ausgestaltete Gitterstruktur hat unterschiedliche Vorteile: zum einen kann auf die Gebäudefassade auftreffendes Sonnenlicht direkt durch die Maschen hindurch auf Solarzellen des Photovoltaikmoduls treffen. Zum anderen können auf die Lamellen auftreffende Lichtstrahlen in Richtung der Solarzellen umgelenkt werden. Ferner verdecken die Lamellen zumindest teilweise den Blick auf die dunklen Solarzellen. Besonders bevorzugt ist es, wenn die Gitterstruktur ein Streckmetall umfasst, insbesondere ein Streckmetall ist. Ein weiterer Vorteil einer solchen Gitterstruktur ist die Tatsache, dass eine sich ergebende rautenförmige Ausbildung der Maschen dazu führt, dass die Gitterstruktur ein Gewebe bildet, welches sich selbst tragen kann und keine seitliche Einfassung braucht. Im Gegensatz dazu sind herkömmliche horizontale Lamellen für Gebäudefassen typischerweise nicht miteinander verbunden und brauchen eine seitliche Einfassung.

Bei vorteilhaften Ausführungsformen beträgt ein Lamellenanstellwinkel zwischen 10 Grad und 70 Grad, bevorzugt zwischen 15 Grad und 65 Grad, besonders bevorzugt zwischen 20 Grad und 60 Grad. Dabei wird der Lamellenanstellwinkel zwischen einer Gitternormalen des Gitters und einer Lamellenquerrichtung gemessen, wobei die Lamellenquerrichtung bevorzugt über eine Länge jeder Lamelle der Gitterstruktur variiert. Eine derart ausgestaltete Gitterstruktur hat den Vorteil, dass der Blick auf die dunklen Solarzellen besonders gut für Personen auf Strassenniveau kaschiert wird, wobei gleichzeitig auf die Lamellen auftreffendes Licht besonders vorteilhaft, insbesondere besonders homogen, auf den Solarzellen des Photovoltaikmoduls verteilt wird. Die Gitterstruktur umfasst typischerweise eine Mehrzahl an Nahtstellen, an welchen jeweils eine Mehrzahl von Lamellen fest miteinander verbunden sind. Bevorzugt sind an jeder Nahtstelle jeweils vier Lamellen fest miteinander verbunden. Bevorzugt sind die Lamellenquerrichtungen an den Nahtstellen einer erfindungsgemässen Gitterstruktur im wesentlichen gleich. Die Lamellenquerrichtung an den Nahtstellen der Gitterstruktur wird als Nahtstellen-Lamellenquerrichtung bezeichnet. Analog dazu wird der Lamellenanstellwinkel an den Nahtstellen als Nahtstellen-Lamellenanstellwinkel bezeichnet. Besonders vorteilhaft ist es dabei wenn der Lamellenanstellwinkel, insbesondere der Nahtstellen-Lamellenanstellwinkel, in Abhängigkeit der geografischen Lage eines Einsatzortes des Photovoltaikmoduls gewählt ist, und zwar insbesondere derart, dass der Nahtstellen-Lamellenanstellwinkel dem maximalen Sonnenhöhenwinkel der Tagundnachtgleiche an dem Einsatzort des Photovoltaikmoduls entspricht. Dies hat, einfach gesprochen, den Vorteil, dass möglichst viel Licht möglichst senkrecht auf ein hinter der Gitterstruktur montiertes Photovoltaikmodul auftrifft, wodurch sich die Energieeffizienz dieses Photovoltaikmoduls verbessert. Mit anderen Worten wird der Wirkungsgrad des Photovoltaikmoduls durch das steilere Auftreffen der Sonnenstrahlen verbessert. Zum Beispiel beträgt der Nahtstellen-Lamellenanstellwinkel bei dem Einsatzort "Luzern/Schweiz" vorteilhafterweise 45 Grad. Bei bevorzugten Ausführungsformen beträgt der Nahtstellen-Lamellenanstellwinkel zwischen 35 und 55 Grad, bevorzugt zwischen 40 und 50 Grad, besonders bevorzugt 45 Grad +/- 1 bis 2 Grad. Bei vorteilhaften Ausführungsformen liegt der Einsatzort in der gemässigten Zone.

Bei vorteilhaften Ausführungsformen beträgt eine Maschenbreite zwischen 2 cm und 20 cm, bevorzugt zwischen 3 cm und 12 cm, besonders bevorzugt zwischen 5 cm und 8 cm und/oder eine Maschenlänge beträgt zwischen 5 cm und 50 cm, bevorzugt zwischen 10 cm und 35 cm, besonders bevorzugt zwischen 15 cm und 25 cm. Solche Dimensionen haben sich bei Praxistests in der gemässigten Zone als besonders vorteilhaft erwiesen.

Bei vorteilhaften Ausführungsformen beträgt eine Schlitzbreite zwischen 1 cm und 18 cm, bevorzugt zwischen 2 cm und 10 cm, besonders bevorzugt zwischen 4 cm und 6 cm und/oder eine Schlitzlänge beträgt zwischen 4 cm und 45 cm, bevorzugt zwischen 9 cm und 30 cm, besonders bevorzugt zwischen 10 cm und 20 cm. Solche Dimensionen haben sich bei Praxistests in der gemässigten Zone als besonders vorteilhaft erwiesen.

Bei vorteilhaften Ausführungsformen beträgt eine Stegbreite der Lamellen zwischen 1 cm und 5 cm, bevorzugt zwischen 1.5 cm und 4 cm, besonders bevorzugt zwischen 2 cm und 2.5 cm. Solche Dimensionen haben sich bei Praxistests in der gemässigten Zone als besonders vorteilhaft erwiesen.

Bei vorteilhaften Ausführungsformen beträgt ein freier Querschnitt der Gitterstruktur zwischen 40% und 70%, bevorzugt zwischen 45% und 65%, besonders bevorzugt zwischen 51% und 63% beträgt. Der Begriff "freier Querschnitt" ist dabei derart zu verstehen, dass bei einer senkrechten Betrachtung der Gitterstruktur (mit anderen Worten: bei einer Betrachtung der Gitterstruktur in entgegengesetzter Richtung der Gitternormalen, auch "90-Grad-Betrachtung" genannt) ein hinter dem Gitter liegender Bereich zu dem jeweils angegebenen Prozentsatz sichtbar ist. Beispielsweise wären bei einer Gitterstruktur, welche die Solarzellen eines Photovoltaikmoduls verdeckt, bei einem freien Querschnitt von 40% bei einer 90-Grad-Betrachtung des Gitters lediglich 40% der Solarzellen sichtbar, wobei 60% der Solarzellen von der Gitterstruktur verdeckt wären.

Bei vorteilhaften Ausführungsformen ist die Gitterstruktur zumindest zum Teil aus Metall und/oder Kunststoff. Diese Materialien sind besonders vorteilhaft, weil sie verhältnismässig günstig sind, weil sie einfach zu verarbeiten sind, und weil sie widerstandsfähig sind.

Eine Gitterstruktur zur Montage auf einem Photovoltaikmodul nach einer Ausführungsform der Erfindung, wobei das Photovoltaikmodul geeignet ist, an einer Gebäudefassade montiert zu werden, ist derart ausgebildet, dass sie auf die Gitterstruktur auftreffende Sonnenstrahlen in Richtung des Photovoltaikmoduls umlenkt, wenn sie auf dem an der Gebäudefassade montierten Photovoltaikmodul montiert ist. Auch diese Gitterstruktur kann natürlich mit einem und/oder mehreren der Merkmale aller vorgenannten Ausführungsformen kombiniert werden.

Ein erfindungsgemässes Photovoltaikmodul umfasst zumindest eine erfindungsgemässe Gitterstruktur und zumindest eine Solarzelle und/oder ein herkömmliches Photovoltaikmodul.

Bei vorteilhaften Ausführungsformen beträgt ein freier Abstand zwischen der Gitterstruktur und der Solarzelle zwischen 5 cm und 50 cm, bevorzugt zwischen 10 cm und 30 cm, besonders bevorzugt zwischen 15 cm und 25 cm. Diese Dimensionen sind deswegen vorteilhaft, weil sie einen besonders guten Kompromiss zwischen homogener Ausleuchtung der Solarzellen des Photovoltaikmoduls, Ventilation, d.h. Kühlung des Photovoltaikmoduls und ästhetischem Erscheinungsbild bieten. Die Gitterstruktur kann sich zudem mit dem Wind etwas seitlich durchbiegen und die Glasoberfläche temporär berühren, was zwar nicht unbedingt zu Beschädigungen führen muss, aber typischerweise zu Klappergeräuschen führt. Desweiteren können sich kleinere Objekte wir Laub oder Plastiktüten, die sich im Gitter verfangen, eher weg geweht werden, wenn der Abstand groß ist. Wird der Abstand aber zu groß, so wird zuviel Grundrissfläche verschenkt. Auch vor dem Hintergrund dieser Anforderungen sind die oben genannten Dimensionen vorteilhaft und stellen eine gute Kompromisslösung dar.

Eine erfindungsgemässe Gebäudefassade umfasst zumindest ein erfindungsgemässes Photovoltaikmodul mit einer erfindungsgemässen Gitterstruktur. Es versteht sich von selbst, dass bei einem solchen Photovoltaikmodul bzw. bei einer solchen Gebäudefassade die Gitterstruktur auf der Seite der Solarzellen des Photovoltaikmoduls angeordnet ist, welche dem Gebäude abgewandt ist, also ganz aussen. Es versteht sich von selbst, dass eine erfindungsgemässe Gebäudefassade z. B. dadurch realisiert werden kann, dass eine Gebäudewand zunächst zumindest auf einer bestimmten Fläche mit einer Mehrzahl an herkömmlichen Photovoltaikmodulen versehen wird und dass anschliessend über diese Photovoltaikmodule zumindest eine erfindungsgemässe Gitterstruktur montiert wird. Bevorzugt beträgt der Nahtstellen-Lamellenanstellwinkel dabei zwischen 35 und 55 Grad, bevorzugt zwischen 40 und 50 Grad, besonders bevorzugt 45 Grad +/- 1 bis 2 Grad. Eine solche Gebäudefassade hat den Vorteil, dass hinter der Gitterstruktur hässliche aber dennoch effiziente Photovoltaikmodule versteckt werden können, die keine besonderen ästhetischen Anforderungen erfüllen müssen. Diese Photovoltaikmodule können zudem Standardmasse haben, weil eventuelle Lücken zwischen den Photovoltaikmodulen nicht sichtbar sind. Ein typisches Standardformat für herkömmliche Photovoltaikmodule beträgt 1m x 1.6 m. Somit fallen auch komplizierte Randabschlüsse und damit verbundene hohe Kosten weg. Ein Nachteil von sichtbaren BIPV-Fassaden ist es nämlich, dass die verwendeten Photovoltaikmodule angepasste Abmessungen haben müssen, um bündig in eine bestehende Fassade integriert werden zu können. Ausserdem müssen sie optisch anspruchsvoll sein. Damit sind sie sehr teuer.

Bei typischen Ausführungsbeispielen umfasst die Gitterstruktur ein Streckmetall, und/oder die Gitterstruktur ist ein Streckmetall. Dabei ist dieses Streckmetall derart an der Gebäudefassade montiert, dass die Lamellen des Streckmetalls als Lichtschaufeln wirken und Sonnenstrahlen in Richtung der Gebäudefassade umlenken. Bei typischen Ausführungsformen umfasst das Streckmetall also eine Mehrzahl an Lamellen, wobei die Lamellen derart ausgerichtet sind, dass sie als Lichtschaufeln wirken, um auf die Gitterstruktur auftreffende Sonnenstrahlen in Richtung des Photovoltaikmoduls und/oder der zumindest einen Solarzelle umzulenken.

Eine solche Montage von Streckmetallen an Gebäudefassaden ist ausgesprochen vorteilhaft, weil dadurch auf einfache Weise eine Umlenkung der Sonnenstrahlen auf in der Gebäudefassade integrierte Photovoltaikmodule erreicht werden kann, wodurch sich bei verhältnismässig homogener Ausleuchtung der Photovoltaikmodule eine besonders gute Energieeffizienz ergibt. Dies wurde vom Erfinder überraschend festgestellt. Streckmetalle werden an Gebäudefassaden nämlich normalerweise zur Verschattung eingesetzt und dazu genau anders herum an der Gebäudefassade montiert - nämlich derart, dass auf die Lamellen des Streckmetalls auftreffende Sonnenstrahlen von der Gebäudefassade weggelenkt werden. Bei dem Einsatz eines Streckmetalls gemäss diesem Ausführungsbeispiel der Erfindung wird der übliche Einsatz des Streckmetalls an einer Gebäudefassade somit gewissermassen auf den Kopf gestellt.

Bei typischen Ausführungsformen beträgt der Lamellenanstellwinkel, bevorzugt der Nahtstellen-Lamellenanstellwinkel, des Streckmetalls zwischen 10 Grad und 70 Grad, bevorzugt wischen 15 Grad und 65 Grad, besonders bevorzugt zwischen 20 Grad und 60 Grad.

Eine erfindungsgemässe Gitterstruktur hat typischerweise eine Länge von 1 m bis 10 m bevorzugt 1.5 m bis 7 m, besonders bevorzugt 2 m bis 5 m und/oder eine Breite von 1 m bis 10 m bevorzugt 1.5 m bis 7 m, besonders bevorzugt 2 m bis 5 m.

Die Erfindung beruht unter anderem auf der überraschenden Erkenntnis, dass das Anordnen einer Gitterstruktur vor einem fassadenintegrierten Photovoltaikmodul die Effizienz dieses Moduls nicht unbedingt so stark herabsetzt, wie man zunächst annehmen könnte. Vielmehr können durch eine geeignete Ausgestaltung der Gitterstruktur z. B. direkte Sonnenstrahlen derart umgelenkt werden, dass sie steiler auf das Photovoltaikmodul auftreffen und somit mehr elektrischen Strom erzeugen. Zudem wirkt eine durch eine erfindungsgemässe Gitterstruktur typischerweise erzeugte Streuung und Kontrastreduktion der Bildung von Hot Spots entgegen.

Alle vorgenannten Ausführungsbeispiele und Ausführungsformen der Erfindung sind miteinander kombinierbar.

### FIGURENBESCHREIBUNG

Nachfolgend wird die Erfindung mit Hilfe von Diagrammen und Zeichnungen näher beschrieben, wobei zeigen:
- Figur 1:: Ausschnitt aus einer erfindungsgemässen Gitterstruktur in Draufsicht ("90-Grad-Betrachtung" bzw. Frontalansicht),
- Figur 2:: Ausschnitt aus einer erfindungsgemässen Gitterstruktur in Ansicht von oben,
- Figur 3:: weiterer Ausschnitt aus einer erfindungsgemässen Gitterstruktur
- Figur 4:: Ausschnitt aus einer erfindungsgemässen Gitterstruktur in Seitenansicht, mit markierten Lamellenanstellwinkeln,
- Figur 5:: Ausschnitt aus einer weiteren erfindungsgemässen Gitterstruktur in Seitenansicht, mit markierten Lamellenanstellwinkeln,
- Figur 6:: Ausschnitt aus einer weiteren erfindungsgemässen Gitterstruktur in Seitenansicht, mit markierten Lamellenanstellwinkeln, und
- Figur 7:: Ausschnitt aus einer erfindungsgemässen Gebäudefassade in seitlicher Schnittansicht.
- Figur 8:: Gitterstruktur-Ausschnitt aus Figur 5, im Zusammenspiel mit einem Photovoltaikmodul.

### Beschreibung bevorzugter Ausführungsbeispiele

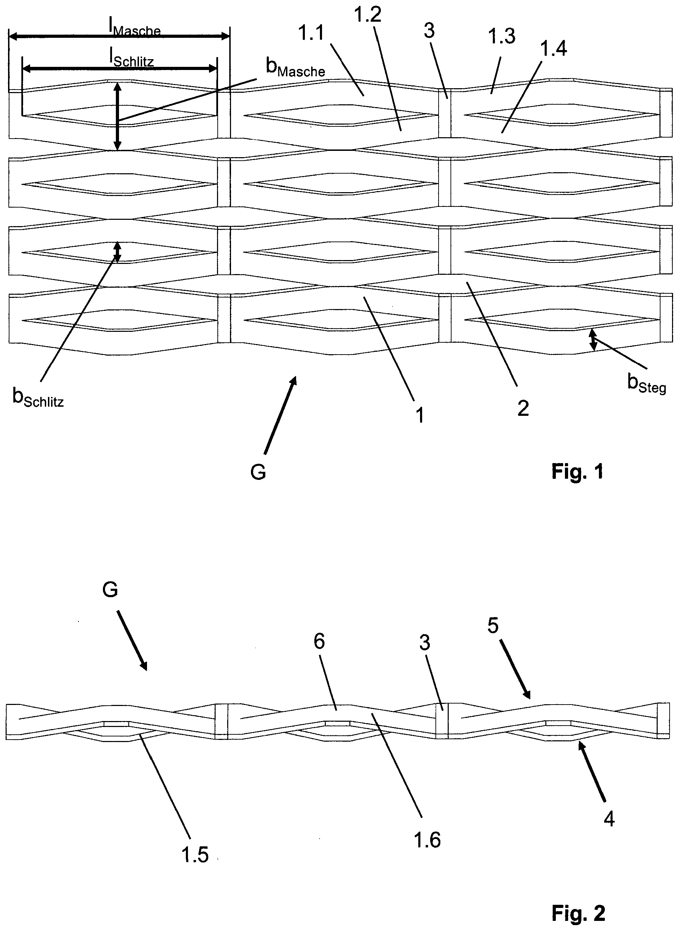

Figur 1 zeigt einen Ausschnitt aus einer erfindungsgemässen Gitterstruktur G in Draufsicht ("90-Grad-Betrachtung"). Die Gitterstruktur G umfasst eine Mehrzahl an Lamellen 1, 1.1, 1.2, 1.3, 1.4, und eine Mehrzahl an Maschen 2. Aus Figur 1 ist ersichtlich, dass jeweils vier Lamellen an einer Nahtstelle 3 fest miteinander verbunden sind. Dies ist in Figur 1 exemplarisch für die Lamellen 1.1, 1.2, 1.3 und 1.4 dargestellt. In Figur 1 sind ausserdem die Maschenlänge I_{Masche,} die Maschenbreite b_{Masche,} die Schlitzlänge I_{Schlitz,} die Schlitzbreite b_{Schlitz} sowie die Stegbreite b_{Steg} der Gitterstruktur G eingezeichnet.
Figur 2 zeigt einen Ausschnitt aus einer weiteren erfindungsgemässen Gitterstruktur G in Ansicht von oben. Aus Figur 2 ist ersichtlich, dass die Gitterstruktur eine Wellenform aufweist. Die Wellenform wird insbesondere dadurch ausgebildet, dass die Gitterstruktur G eine erste Lamellenreihe 4 und eine zweite Lamellenreihe 5 umfasst, wobei die erste Lamellenreihe 4 und die zweite Lamellenreihe 5 jeweils drei Lamellen 1.5 und 1.6 umfassen. Dabei sind in Figur 2 in den beiden Lamellenreihen 4 und 5 der besseren Übersicht halber lediglich jeweils eine Lamelle 1.5 und 1.6 mit Bezugszeichen versehen. Aus
Figur 2 ist zudem ersichtlich, dass die Lamellen 1.5 der ersten Lamellenreihe 4 und die Lamellen 1.6 der zweiten Lamellenreihe 5 jeweils in entgegengesetzte Richtungen gebogen sind, insbesondere derart, dass jeweilige Lamellenmitten 6 jeweils bezüglich einer resultierenden Gitterfläche nach aussen verlagert sind. Zudem sind jeweils vier Lamellen, insbesondere jeweils zwei Lamellen der ersten Lamellenreihe 4 und jeweils zwei Lamellen der zweiten Lamellenreihe an Nahtstellen 3 miteinander fest verbunden. Somit ergibt sich die vorbezeichnete Wellenform der Gitterstruktur G, wobei insbesondere die erste Lamellenreihe 4 eine rückläufige Wellenform hat und die zweite Lamellenreihe 5 eine vorläufige Wellenform hat. Mit anderen Worten bilden die beiden Lamellenreihen 4 und 5 gegenläufige Wellenformen aus. Eine erfindungsgemässe Gitterstruktur kann selbstverständlich mehr als zwei Lamellenreihen, insbesondere eine Mehrzahl an Lamellenreihen, mit jeweils mehr als drei Lamellen, insbesondere einer Mehrzahl an Lamellen, umfassen.

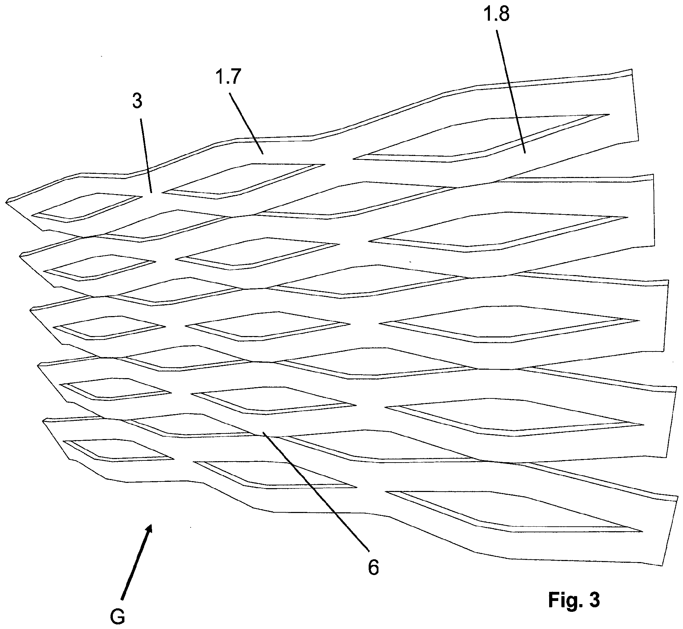

Figur 3 zeigt einen weiteren Ausschnitt aus einer erfindungsgemässen Gitterstruktur G in Schrägansicht von oben, d.h. aus Sicht der Sonne, mit einer Mehrzahl an (bezüglich der Darstellung in Figur 3) nach vorne gebogenen Lamellen 1.8 einer Mehrzahl an nach hinten gebogenen Lamellen 1.7, einer Mehrzahl an Nahtstellen 3, sowie einer Mehrzahl an Lamellenmitten 6.

Bei jedem Ausführungsbeispiel ist es möglich, dass die Nahstellen 3 und die Lamellenmitten im wesentlichen gleich ausgebildet sind, mit anderen Worten, dass es keine wesentlichen Unterschiede zwischen Nahtstellen 3 und Lamellenmitten 6 gibt, beziehungsweise, dass eine Nahtstelle 3 immer auch eine Lamellenmitte 6 darstellt, je nachdem welche Masche 2 man gerade betrachtet. Dies lässt sich am besten verstehen, wenn man sich vor Augen führt, dass eine erfindungsgemässe Gitterstruktur G typischerweise dadurch hergestellt wird, dass ein Blech mit Schlitzen versehen und anschliessend derart gezogen und/oder gebogen wird, dass die beschriebene Struktur mit Lamellen und Maschen entsteht.

Aus Figur 3 ist ferner ersichtlich, dass jeweils zwei Lamellen, insbesondere eine nach vorne gebogene Lamelle und eine nach hinten gebogene Lamelle, an ihren jeweiligen Lamellenmitten fest miteinander verbunden sind. Es fällt auf, dass bei diesem Betrachterwinkel der freie Querschnitt, d.h. die Verschattung des PV Moduls, am geringsten ist. Bei einer Betrachtung von unten ist der Durchblick auf das dahinterliegende Photovoltaikmodul entsprechend am stärksten eingeschränkt.

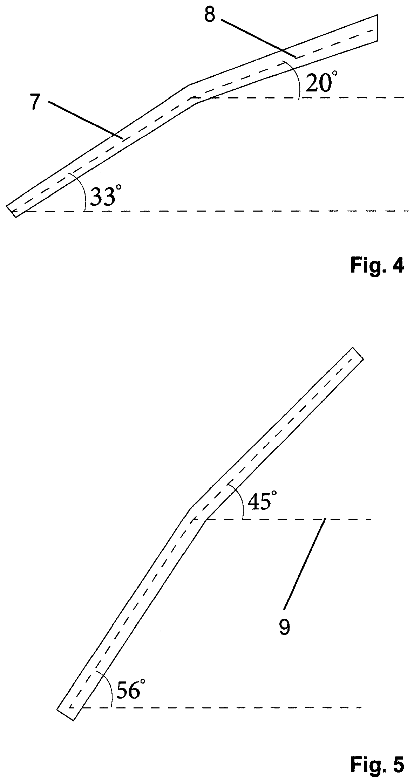

Figuren 4 bis 6 zeigen jeweils Ausschnitte aus erfindungsgemässen Gitterstrukturen G (in unterschiedlicher Grösse) in Seitenansicht, mit markierten Lamellenanstellwinkeln. Die Lamellenanstellwinkel werden jeweils zwischen einer den Lamellenquerrichtungen 7 und 8 (exemplarisch in Figur 4 mit Bezugszeichen versehen) und der Gitternormalen 9 (exemplarisch in Figur 5 mit Bezugszeichen versehen) gemessen. Die in Figuren 4 bis 6 dargestellten Gitterstrukturen G sind jeweils an Nahtstellen 3 (siehe Figuren 1 bis 3) geschnitten, wobei die Nahtstellen 3 ihrer Länge nach mittig durchgeschnitten gezeigt sind. Hierbei fällt auf, dass bei den gezeigten Ausführungsformen jede Nahtstelle genau genommen nicht einen einzigen Nahtstellen-Lamellenanstellwinkel hat, sondern zwei. Unter dem im allgemeinen Teil der Beschreibung bezeichneten Nahtstellen-Lamellenanstellwinkel ist somit ein resultierender Nahtstellen-Lamellenanstellwinkel zu verstehen, welcher beispielsweise dem arithmetischen Mittelwert der in Figuren 4 bis 6 jeweils zwei erkennbaren Lamellenanstellwinkeln entspricht.

Es versteht sich von selbst, dass die Gitterstrukturen G, von welchen in den Figuren 4 bis 6 jeweils Ausschnitte in Seitenansicht dargestellt sind, jeweils so an einer Gebäudefassade montiert werden, dass sie auf sie einfallendes Sonnenlicht auf ein in der Gebäudefassade integriertes Photovoltaikmodul umlenken. Dies ist in den in Figuren 4 bis 6 dargestellten Ausführungsbeispielen jeweils dann der Fall, wenn die Photovoltaikmodule jeweils links von den Gitterstrukturen G angeordnet sind. Figuren 4 bis 6 zeigen jedoch nur die Gitterstrukturen G mit den jeweils unterschiedlichen Nahtstellen-Lamellenanstellwinkeln, nicht jedoch Photovoltaikmodule.

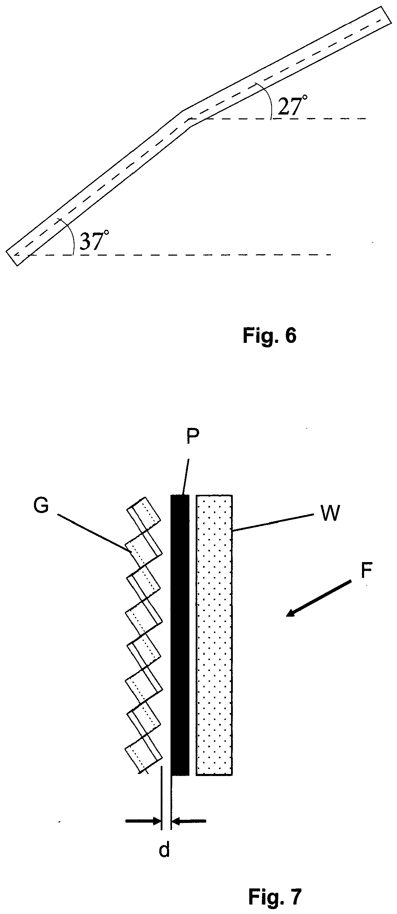

Figur 7 zeigt einen Ausschnitt aus einer erfindungsgemässen Gebäudefassade F in seitlicher Schnittansicht. Die Gebäudefassade F umfasst eine Wand W, ein auf der Wand W angeordnetes herkömmliches Photovoltaikmodul P und eine auf dem Photovoltaikmodul P angeordnete Gitterstruktur G. Die Gitterstruktur G ist in einem Abstand d zum Photovoltaikmodul P angeordnet. An dieser Stelle sei darauf hingewiesen, dass ein erfindungsgemässes Photovoltaikmodul mit Vorteil ein herkömmliches Photovoltaikmodul P und eine erfindungsgemässe Gitterstruktur G umfasst.

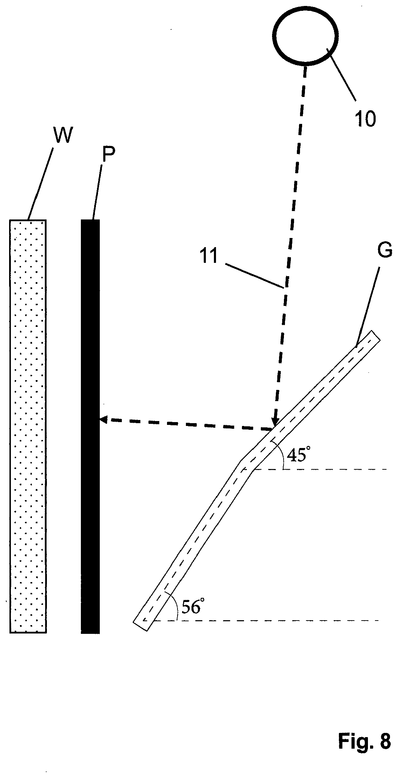

Figur 8 zeigt die Gitterstruktur G, welche bereits in Figur 5 dargestellt ist, im Zusammenspiel mit einem Photovoltaikmodul P. Das Photovoltaikmodul P ist an einer Wand W eines ansonsten nicht weiter dargestellten Gebäudes montiert. In Figur 8 ist ferner die Sonne 10 dargestellt, welche einen Sonnenstrahl 11 aussendet; es ist exemplarisch lediglich ein Sonnenstrahl gezeigt, obwohl die Sonne 10 in der Realität natürlich unendlich viele Sonnenstrahlen aussendet. Dieser Sonnenstrahl 11 trifft auf die Gitterstruktur G und wird von dort in Richtung des Photovoltaikmoduls P umgeleitet. Die Gitterstruktur G ist derart ausgebildet, dass sie geeignet ist, auf sie auftreffendes Licht, insbesondere direktes Sonnenlicht, in Richtung des Photovoltaikmoduls P umzulenken. Insbesondere ist die Lamellenquerrichtung der Gitterstruktur G dazu schräg nach oben, also Richtung Himmel, ausgerichtet. Die Lamellen der Gitterstruktur G wirken somit als Lichtschaufeln.

Diese Umlenkung von Sonnenstrahlen trägt dazu bei, dass eine verhältnismässig homogene Ausleuchtung des Photovoltaikmoduls P erreicht wird. Auf diese Weise wird eine gute Energieeffizienz für das Photovoltaikmodul P erreicht, unter anderem deshalb, weil die Sonnenstrahlen 10 durch das Umlenken an der Gitterstruktur G in steileren Winkeln auf das Photovoltaikmodul P auftreffen. Dadurch wird weniger Sonnenlicht an der Glasoberfläche des Photovoltaikmoduls P reflektiert, und der Lichtdurchlass zu den Solarzellen ist somit höher.

Würde die Gitterstruktur G anders herum (also gewissermassen auf dem Kopf stehend bzw. mit schräg nach unten zeigenden Lamellenquerrichtungen) an dem Photovoltaikmodul P montiert, dann wäre eine Umlenkung der Sonnenstrahlen in Richtung des Photovoltaikmoduls nicht möglich. Vielmehr würden die auf die Gitterstruktur G auftreffenden Sonnenstrahlen von der Fassade weggelenkt. Eine solche Gitterstruktur würde sich dann zur Verschattung einer Gebäudefassade eignen, denn die auf die Gitterstruktur auftreffenden Sonnenstahlen würden dann von der Gebäudefassade weggelenkt. Auch auf eine solche genau anders herum montierte Gitterstruktur auftreffender Regen würde vom Photovoltaikmodul weg, das heisst nach aussen hin, abgeleitet.

Aus den Darstellungen in Figuren 4 bis 8 ergibt sich, dass bei einer an einer Gebäudefassade montierten Gitterstruktur die Gitternormale senkrecht von der Gebäudefassade weg zeigt und die Lamellenquerrichtung schräg nach oben (also schräg gen Himmel) von der Gebäudefassade weg zeigt.

### Bezugszeichenliste

- 2 1, 1.1, 1.2, 1.3, 1.4, 1.5, 1.6, 1.7, 1.8: Lamelle Masche
- 3: Nahtstelle
- 4: erste Lamellenreihe
- 5: zweite Lamellenreihe
- 6: Lamellenmitte
- 7, 8: Lamellenquerrichtung
- 9: Gitternormale
- 10: Sonne
- 11: Sonnenstrahl
- F: Gebäudefassade
- G: Gitterstruktur
- P: Photovoltaikmodul
- W: Wand
- d: Abstand zwischen Gitterstruktur G und Photovoltaikmodul P
- I: diverse Längen (laut Index)
- b: diverse Breiten (laut Index)

## Patentansprüche

1. Gebäudefassade (F), umfassend eine Wand (W), zumindest ein Photovoltaikmodul (P) mit zumindest einer Solarzelle und eine Gitterstruktur (G), wobei
- das Photovoltaikmodul (P) auf der Wand (W) angeordnet ist, **dadurch gekennzeichnet**, das:
- die Gitterstruktur auf dem Photovoltaikmodul (P) montiert ist,
- die Gitterstruktur (G) derart ausgebildet ist, dass sie geeignet ist, auf die Gitterstruktur (G) treffendes Licht in Richtung des Photovoltaikmoduls (P) umzulenken,
- wobei die Gitterstruktur (G) eine Mehrzahl an Lamellen (1) und eine Mehrzahl an Maschen (2) umfasst,
- wobei ein Lamellenanstellwinkel zwischen 10 Grad und 70 Grad beträgt, wobei der Lamellenanstellwinkel zwischen einer Gitternormalen (9) des Gitters und einer Lamellenquerrichtung (7, 8) gemessen wird.

2. Gebäudefassade (F) nach Anspruch 1, **dadurch gekennzeichnet, dass** der Lamellenanstellwinkel zwischen 15 Grad und 65 Grad, besonders bevorzugt zwischen 20 Grad und 60 Grad beträgt, wobei die Lamellenquerrichtung (7, 8) bevorzugt über eine Länge jeder Lamelle der Gitterstruktur (G) variiert.

3. Gebäudefassade (F) nach einem der vorhergehenden Ansprüche, **dadurch gekennzeichnet, dass** eine Maschenbreite (b_{Masche}) zwischen 2 cm und 20 cm, bevorzugt zwischen 3 cm und 12 cm, besonders bevorzugt zwischen 5 cm und 8 cm beträgt und/oder dass eine Maschenlänge (I_{Masche}) zwischen 5 cm und 50 cm, bevorzugt zwischen 10 cm und 35 cm, besonders bevorzugt zwischen 15 cm und 25 cm beträgt.

4. Gebäudefassade (F) nach einem der vorhergehenden Ansprüche, **dadurch gekennzeichnet, dass** eine Schlitzbreite (b_{Schlitz}) zwischen 1 cm und 18 cm, bevorzugt zwischen 2 cm und 10 cm, besonders bevorzugt zwischen 4 cm und 6 cm beträgt und/oder dass eine Schlitzlänge (I_{Schlitz}) zwischen 4 cm und 45 cm, bevorzugt zwischen 9 cm und 30 cm, besonders bevorzugt zwischen 10 cm und 20 cm beträgt.

5. Gebäudefassade (F) nach einem der vorhergehenden Ansprüche, **dadurch gekennzeichnet, dass** eine Stegbreite (bsteg) zwischen 1 cm und 5 cm, bevorzugt zwischen 1.5 cm und 4 cm, besonders bevorzugt zwischen 2 cm und 2.5 cm beträgt.

6. Gebäudefassade (F) nach einem der vorhergehenden Ansprüche, **dadurch gekennzeichnet, dass** ein freier Querschnitt der Gitterstruktur (G) zwischen 40% und 70%, bevorzugt zwischen 45% und 65%, besonders bevorzugt zwischen 51% und 63% beträgt.

7. Gebäudefassade (F) nach einem der vorhergehenden Ansprüche, **dadurch gekennzeichnet, dass** die Gitterstruktur (G) zumindest zum Teil aus Metall und/oder Kunststoff ist.

8. Gebäudefassade (F) nach einem der vorhergehenden Ansprüche, **dadurch gekennzeichnet, dass** die Gitterstruktur (G) ein Streckmetall umfasst.

9. Gebäudefassade (F) nach einem der vorhergehenden Ansprüche, **dadurch gekennzeichnet, dass** die Gitterstruktur (G) ein Streckmetall umfasst, wobei das Streckmetall eine Mehrzahl an Lamellen umfasst, wobei die Lamellen derart ausgerichtet sind, dass sie als Lichtschaufeln wirken, um auf die Gitterstruktur auftreffende Sonnenstrahlen in Richtung des Photovoltaikmoduls und/oder der zumindest einen Solarzelle umzulenken.

10. Gebäudefassade (F) nach Anspruch 9, **dadurch gekennzeichnet, dass** ein Lamellenanstellwinkel, bevorzugt ein Nahtstellen-Lamellenanstellwinkel, des Streckmetalls zwischen 10 Grad und 70 Grad, bevorzugt wischen 15 Grad und 65 Grad, besonders bevorzugt zwischen 20 Grad und 60 Grad beträgt.

11. Gebäudefassade (F) nach einem der vorhergehenden Ansprüche, **dadurch gekennzeichnet, dass** ein freier Abstand (d) zwischen der Gitterstruktur (G) und der Solarzelle zwischen 5 cm und 50 cm, bevorzugt zwischen 10 cm und 30 cm, besonders bevorzugt zwischen 15 cm und 25 cm beträgt.

## Claims

1. Building facade (F) comprising a wall (W), at least one photovoltaic module (P) with at least one solar cell and a grid structure (G), wherein
- the photovoltaic module (P) is arranged on the wall (W),
**characterized in that**
- the grid structure is mounted on the photovoltaic module (P),
- the grid structure (G) is configured in such a way that it is adapted to redirect light hitting the grid structure (G) towards the photovoltaic module (P),
- wherein the grid structure (G) comprises a multitude of lamellae (1) and a multitude of meshes (2),
- wherein a lamella pitch angle equals between 10 degrees and 70 degrees, wherein the lamella pitch angle is measured between a grid normal (9) of the grid and a lamella transverse direction (7, 8).

2. Building facade (F) according to claim 1, **characterized in that** the lamella pitch angle equals between 15 degrees and 65 degrees, particularly preferably between 20 degrees and 60 degrees, wherein the lamella transverse direction (7, 8) preferably varies across a length of each lamella of the grid structure (G).

3. Building facade (F) according to any of the previous claims, **characterized in that** a mesh width (b_{Masche}) equals between 2 cm and 20 cm, preferably between 3 cm and 12 cm, particularly preferably between 5 cm and 8 cm and/or that a mesh length (I_{Masche}) equals between 5 cm and 50 cm, preferably between 10 cm and 35 cm, particularly preferably between 15 cm and 25 cm.

4. Building facade (F) according to any of the previous claims, **characterized in that** a slid width (b_{Schlitz}) equals between 1 cm and 18 cm, preferably between 2 cm and 10 cm, particularly preferably between 4 cm and 6 cm and/or that a slid length (I_{Schlitz}) equals between 4 cm and 45 cm, preferably between 9 cm and 30 cm, particularly preferably between 10 cm and 20 cm.

5. Building facade (F) according to any of the previous claims, **characterized in that** a bar width (b_{Steg}) equals between 1 cm and 5 cm, preferably between 1.5 cm and 4 cm, particularly preferably between 2 cm and 2.5 cm.

6. Building facade (F) according to any of the previous claims, **characterized in that** a free cross section of the grid structure (G) equals between 40% and 70%, preferably between 45% and 65%, particularly preferably between 51% and 63%.

7. Building facade (F) according to any of the previous claims, **characterized in that** the grid structure (G) is at least partially made from metal and/or plastic.

8. Building facade (F) according to any of the previous claims, **characterized in that** the grid structure (G) comprises an expanded metal.

9. Building facade (F) according to any of the previous claims, **characterized in that** the grid structure (G) comprises an expanded metal, wherein the expanded metal comprises a multitude of lamellae, wherein the lamellae are directed in such a way that they are acting as light scoops for redirecting sunrays hitting the grid structure towards the photovoltaic module and/or the at least one solar cell.

10. Building facade (F) according to claim 9, **characterized in that** the lamella pitch angle, preferably a junction lamella pitch angle, of the expanded metal equals between 10 degrees and 70 degrees, preferably between 15 degrees and 65 degrees, particularly preferably between 20 degrees and 60 degrees.

11. Building facade (F) according to any of the previous claims, **characterized in that** a free distance (d) between the grid structure (G) and the solar cell equals between 5 cm and 50 cm, preferably between 10 cm and 30 cm, particularly preferably between 15 cm and 25 cm.

## Revendications

1. Façade de bâtiment (F), comprenant un mur (W), au moins un module photovoltaïque (P) avec au moins une cellule solaire et une structure de grille (G), où
- le module photovoltaïque (P) est arrangé sur le mur (W),
**caractérisée en ce que**
- la structure de grille (G) est montée sur le module photovoltaïque (P),
- la structure de grille (G) est configurée telle qu'elle est adaptée à rediriger de la lumière qui atteigne la structure de grille (G) en direction du module photovoltaïque (P),
- où la structure de grille (G) comprend une pluralité de lamelles (1) et une pluralité de mailles (2),
- où l'angle d'attaque de lamelle est entre 10 degrés et 70 degrés, où l'angle d'attaque de lamelle est mesuré entre une normale de grille (9) de la grille et une direction transversale de lamelle (7, 8).

2. Façade de bâtiment (F) selon la revendication 1, **caractérisée en ce que** l'angle d'attaque de lamelle est entre 15 degrés et 65 degrés, particulièrement préférablement entre 20 degrés et 60 degrés, où la direction transversale de lamelle (7, 8) varie préférablement à travers une longueur de chaque lamelle de la structure de grille (G).

3. Façade de bâtiment (F) selon l'une quelconque des revendications précédentes, **caractérisée en ce qu'**une largeur de maille (b_{Masche}) est entre 2 cm et 20 cm, préférablement entre 3 cm et 12 cm, particulièrement préférablement entre 5 cm et 8 cm et/ou qu'une longueur de maille (I_{Masche}) entre 5 cm et 50 cm, préférablement entre 10 cm et 35 cm, particulièrement préférablement entre 15 cm et 25 cm.

4. Façade de bâtiment (F) selon l'une quelconque des revendications précédentes, **caractérisée en ce qu'**une largeur d'échancrure (b_{Schlitz}) est entre 1 cm et 18 cm, préférablement entre 2 cm et 10 cm, particulièrement préférablement entre 4 cm et 6 cm et/ou qu'une longueur d'échancrure (I_{Schlitz}) est entre 4 cm et 45 cm, préférablement entre 9 cm et 30 cm, particulièrement préférablement entre 10 cm et 20 cm.

5. Façade de bâtiment (F) selon l'une quelconque que des revendications précédentes, **caractérisée en ce qu'**une largueur de traverse (bsteg) est entre 1 cm et 5 cm, préférablement entre 1.5 cm et 4 cm, particulièrement préférablement entre 2 cm et 2.5 cm.

6. Façade de bâtiment (F) selon l'une quelconque des revendications précédentes, **caractérisée en ce qu'**une section transversale libre de la structure de grille (G) est entre 40% et 70% préférablement entre 45% et 65%, particulièrement préférablement entre 51% et 63%.

7. Façade de bâtiment (F) selon l'une quelconque des revendications précédentes, **caractérisée en ce que** la structure de grille (G) est au moins partiellement faite en métal et/ou en matière artificielle.

8. Façade de bâtiment (F) selon l'une quelconque des revendications précédentes, **caractérisée en ce que** la structure de grille (G) comprend un métal déployé.

9. Façade de bâtiment (F) selon l'une quelconque des revendications précédentes, **caractérisée en ce que** la structure de grille (G) comprend un métal déployé, où le métal déployé comprend une pluralité de lamelles, où les lamelles sont orientées telles qu'elles fonctionnent comme pelles de lumière afin de redirectionner des rayons de soleil qui atteignent la structure de grille en direction du module photovoltaïque et/ou de l'au moins une cellule solaire.

10. Façade de bâtiment (F) selon la revendication 9, **caractérisée en ce que** l'angle d'attaque de lamelle, préférablement un angle d'attaque de lamelle de jonction, du métal déployé est entre 10 degrés et 70 degrés, préférablement entre 15 degrés et 65 degrés, particulièrement préférablement entre 20 degrés et 60 degrés.

11. Façade de bâtiment (F) selon l'une quelconque des revendication précédentes, **caractérisée en ce qu'**une distance libre (d) entre la structure de grille (G) et la cellule solaire est entre 5 cm et 50 cm, préférablement entre 10 cm et 30 cm, particulièrement préférablement entre 15 cm et 25 cm.
